# FASCICULE DE BREVET EUROPEEN

(11) **EP 2 178 111 B1**
(45) Date de publication et mention de la délivrance du brevet: **24.08.2011**
(21) Numéro de dépôt: 09172758.6
(22) Date de dépôt: 12.10.2009
(51) Int. Cl.: H01L 21/336, H01L 21/762, H01L 21/84

(54) **Procédé de fabrication de composants empilés et auto-alignés sur un substrat**
Herstellungsverfahren von gestapelten und selbstausgerichteten Komponenten auf einem Substrat
Method for manufacturing components stacked and self-aligned on a substrate

(30) Priorité: 17.10.2008 FR 0857060
(43) Date de publication de la demande: 21.04.2010
(73) Titulaire: Commissariat à l'Énergie Atomique et aux Énergies Alternatives, 75015 Paris (FR)
(72) Inventeur: Wacquez, Romain, 38000, GRENOBLE (FR); Coronel, Philippe, 38530, BARRAUX (FR); Destefanis, Vincent, 38000, GRENOBLE (FR); Hartmann, Jean-Michel, 38420 Le Versoud (FR)
(74) Mandataire: Ilgart, Jean-Christophe

(56) Documents cités:
- EP-A- 1 881 533
- FR-A- 2 838 238
- FR-A- 2 897 201
- US-A1- 2005 020 085
- US-A1- 2007 190 787

## Description

### DOMAINE TECHNIQUE

L'invention se rapporte à un procédé de fabrication de composants empilés et auto-alignés sur un substrat.

Elle s'applique en particulier, mais pas exclusivement, à la réalisation de fonctions empilées auto-alignées constituant des composants ou des parties de composants électroniques, des éléments de MEMS, etc...

### ÉTAT DE LA TECHNIQUE ANTÉRIEURE

La réalisation de composants empilés les uns sur les autres connaît un succès certain que ce soit en microélectronique ou dans d'autres domaines (MEMS...). Il est même possible d'empiler des composants tels que des transistors et des MEMS. Ce concept fait cependant souvent appel à des procédés complexes, lourd en budget thermique et/ou couteux (recristallisation de silicium, collage moléculaire, recroissance à travers un contact, nombreuses lithographies...).

Parmi les techniques connues de réalisation de fonctions empilées, on peut citer les techniques suivantes.

Une première technique met en oeuvre une reprise d'épitaxie à travers des trous de contact. La croissance épitaxiale est assistée par laser. Cette technique a été proposée dans le cadre de la réalisation de SRAM 3D. On peut se référer à ce sujet à la publication suivante : « High Speed and Highly Cost effective 72M bit density S3SRAM Technology with Doubly Stacked Si Layers, Peripheral only CoSix layers and Tungsten Shunt W/L Scheme for Standalone and Embedded Memory" de S.-M. JUNG et al., VLSI Technology, 2007 IEEE Symposium on, 12-14 juin 2007, pages 82-83.

Par ailleurs, on connaît une technique qui permet d'aligner des composants entre eux. Elle comprend les étapes suivantes :
- on forme tout d'abord un pont, constitué par une couche mince, au-dessus d'un substrat,
- on dépose une couche de résine sur le substrat, le pont étant noyé dans la résine,
- on soumet localement la résine à un faisceau d'électrons suffisamment puissant pour traverser la couche mince et obtenir en alignement des zones de résine soumises au faisceau d'électrons au-dessous et au-dessus du pont,
- on développe la résine pour ne garder que des zones de résine alignées au-dessus et au-dessous du pont.

Cette technique est notamment exploitée dans le document FR-A-2 858 876 correspondant au document US 2005/0037603.

Une autre technique est décrite dans le document FR-A- 2 838 238. Par ailleurs, on connaît un procédé de gravure sélective du SiGe par rapport au silicium au moyen de gaz HCl. La vitesse de gravure du SiGe, sélectivement par rapport au silicium, en utilisant du gaz HCl, est notamment fonction de la température de gravure et du pourcentage de germanium dans le SiGe. On peut se référer à ce sujet au document US 2007/0190787.

### EXPOSÉ DE L'INVENTION

Comme décrit précédemment, la réalisation de fonctions empilées auto-alignées nécessite l'emploi de méthodes à forts budgets thermiques (recristallisation de silicium à travers des trous de contact), de méthodes complexes (croissance épitaxiale assistée par laser) ou chères (emploi de plusieurs jeux de masques de lithographie).

La présente invention décrit un procédé pour empiler sur plusieurs niveaux (au moins deux) des composants auto-alignés et isolés électriquement entre eux (semiconducteurs, microrésonateurs...) par une couche d'isolant. Aucune méthode de recristallisation du silicium, de recroissance à travers un contact n'est nécessaire, limitant ainsi les contraintes de budget thermique. Les empilements sont définis dès la première opération par épitaxie. Des gravures sélectives et l'utilisation de la lithographie auto-alignée permettent ensuite de travailler à travers la membrane.

L'invention a pour objet un procédé de fabrication de composants empilés et auto-alignés sur un substrat, comprenant les étapes suivantes :
- fourniture d'un substrat en silicium monocristallin présentant une face permettant la fabrication d'un composant,
- formation d'un empilement de couches sur la face du substrat, l'empilement comprenant une première couche sacrificielle en SiGe monocristallin formée sur la face du substrat, une deuxième couche sacrificielle en SiGe monocristallin formée sur la première couche sacrificielle, la concentration en germanium de la première couche sacrificielle étant comprise entre 30% et 100%, la concentration en germanium de la deuxième couche sacrificielle étant comprise entre 10% et 30%, la concentration en germanium de la première couche sacrificielle étant d'au moins 15% supérieure à la concentration en germanium de la deuxième couche sacrificielle, et une couche superficielle en silicium monocristallin permettant la fabrication d'un composant et formée sur la deuxième couche sacrificielle, lesdites couches de l'empilement étant formées de façon à permettre un accès à au moins une zone de la première couche sacrificielle et à au moins une zone de la deuxième couche sacrificielle, ces zones étant empilées,

- gravure sélective de ladite zone de la première couche sacrificielle par un mélange gazeux comprenant du HCl gazeux véhiculé par un gaz porteur et à une température comprise entre 450°C et 900°C, la deuxième couche sacrificielle et la couche superficielle formant un pont au-dessus de la zone gravée de la première couche sacrificielle,
- dépôt de résine dans la zone gravée de la première couche sacrificielle et sur la couche superficielle, la résine étant une résine qui se transforme en matériau diélectrique après recuit,
- lithographie de la résine déposée à l'étape précédente pour laisser subsister au moins une zone de résine dans la zone gravée de la première couche sacrificielle, en alignement avec au moins une zone de résine sur la couche superficielle,

- remplacement de la résine éliminée au cours de l'étape de lithographie dans la zone gravée de la première couche sacrificielle et sur la couche superficielle par un matériau de confinement de la résine subsistante,
- élimination des zones de résine subsistantes dans la zone gravée de la première couche sacrificielle et sur la couche superficielle pour fournir des zones dédiées à la fabrication de composants,
- formation d'éléments de composants dans les zones dédiées,
- gravure sélective de ladite zone de la deuxième couche sacrificielle, la couche superficielle formant un pont au-dessus de ladite zone gravée de la deuxième couche sacrificielle.

L'étape de fourniture d'un substrat peut consister à fournir un substrat choisi parmi un substrat de silicium massif, un substrat SOI, un substrat sSOI, un substrat XsSOI et un substrat virtuel de SiGe. Ladite face du substrat peut comprendre au moins un composant ou au moins une partie de composant.

De préférence, la résine déposée dans la zone gravée de la première couche sacrificielle et la résine déposée sur la couche superficielle sont une résine qui se transforme en matériau diélectrique après exposition et/ou recuit, par exemple une résine HSQ (hydrogène silsesquioxane).

Le matériau de confinement peut être du nitrure de silicium.

Selon un mode de mise en oeuvre, l'étape de formation d'éléments de composants comprend la formation d'au moins un élément de grille de transistor.

Selon une variante de réalisation, l'étape de gravure sélective de ladite zone de la deuxième couche sacrificielle est suivie d'une étape de remplissage de la zone gravée de la deuxième couche sacrificielle par un matériau électriquement isolant. Ce matériau peut être de l'oxyde de silicium.

Il peut être prévu une étape d'élimination du matériau de confinement.

L'étape de lithographie peut être réalisée au moyen d'un faisceau d'électrons traversant la deuxième couche sacrificielle.

Elle peut aussi être réalisée au moyen d'un rayonnement électromagnétique de longueur d'onde comprise entre 0,1 nm et 41 nm, l'épaisseur et la nature de la résine déposée sur la couche superficielle ainsi que l'épaisseur de la couche superficielle étant choisies de manière qu'au moins 50% du rayonnement électromagnétique appliqué à la résine déposée sur la couche superficielle soit transmis à la résine déposée dans la zone gravée de la première couche sacrificielle. Selon un mode de mise en oeuvre particulier, la longueur d'onde du rayonnement électromagnétique est comprise entre 12,5 nm et 15 nm.

### BRÈVE DESCRIPTION DES DESSINS

L'invention sera mieux comprise et d'autres avantages et particularités apparaîtront à la lecture de la description qui va suivre, donnée à titre d'exemple non limitatif, accompagnée des dessins annexés parmi lesquels :
- les figures 1A à 1J sont des vues en coupe transversale illustrant différentes étapes d'un mode de mise en oeuvre du procédé de fabrication de composants empilés et auto-alignés sur un substrat, selon l'invention,
- la figure 2 est un schéma électrique d'un inverseur réalisé en technologie CMOS,
- les figures 3A et 3B sont des vues respectivement en coupe transversale et de dessus d'un inverseur CMOS empilé sur deux niveaux, selon la présente invention.

### EXPOSÉ DÉTAILLÉ DE MODES DE RÉALISATION PARTICULIERS

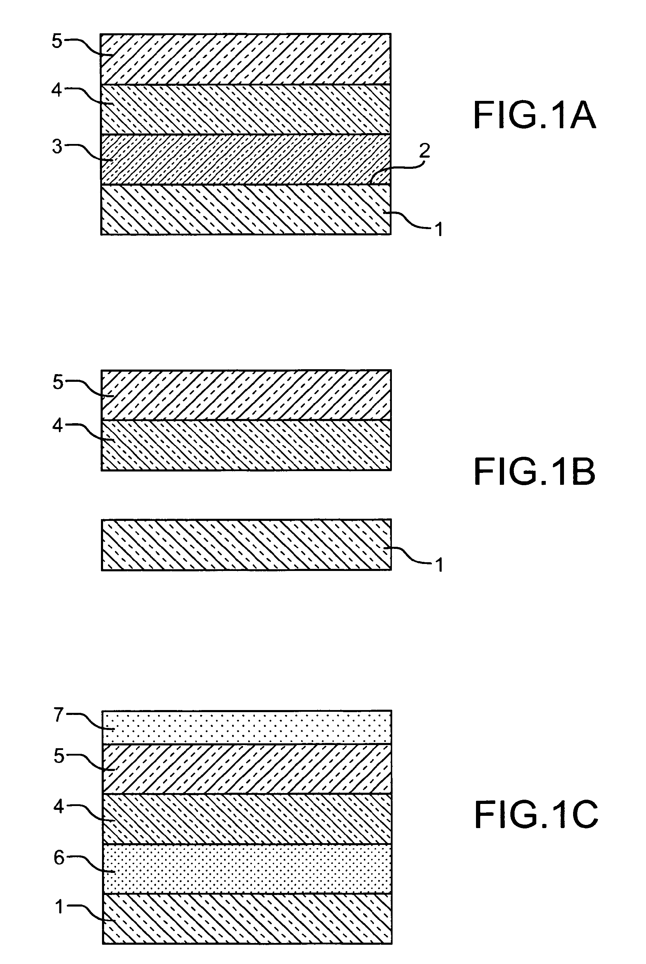

Les figures 1A à 1J sont des vues en coupe transversale illustrant différentes étapes d'un mode de mise en oeuvre du procédé de fabrication de composants empilés et auto-alignés sur un substrat, selon l'invention. Par souci de simplification, la fabrication d'un seul composant est représentée.

La figure 1A montre un substrat 1 présentant une face 2 permettant la fabrication d'un composant. Un empilement de couches est formé sur la face 2 du substrat 1. L'empilement comprend une première couche sacrificielle 3 formée sur la face 2 du substrat 1, une deuxième couche sacrificielle 4 formée sur la première couche sacrificielle 3 et une couche superficielle 5 permettant la fabrication d'un composant et formée sur la deuxième couche sacrificielle 4.

Les différentes couches de l'empilement sont formées de façon à permettre un accès à au moins une zone de la première couche sacrificielle 3 et à au moins une zone de la deuxième couche sacrificielle 4. Dans cet exemple de réalisation, la couche superficielle 5 possède au moins une zone, non représentée sur la figue 1A, la rendant solidaire du substrat 1 en dehors des couches sacrificielles 3 et 4.

L'accès aux zones à graver sélectivement peut être réalisé par des étapes de photo-lithographie suivies d'étapes de gravure. Il peut également être réalisé par des étapes technologiques menant à la réalisation d'architectures SON (pour « Silicon On Nothing ») ou LSOI (pour « Localized Silicon On Insulator »). Pour l'architecture SON, on pourra se référer à l'article « Silicon-on-Nothing (SON)-an innovative process for advanced CMOS » de M. JURCZAK et al., IEEE Transactions on Electron Devices, vol. 47, n°11, pages 2179 à 2187, novembre 2000. Pour l'architecture LSOI, on pourra se référer à l'article « Localized SOI Technology : an innovative Low Cost self-aligned process for Ultra Thin Si-Film on thin BOX integration for Low Power applications » de S. MONFRAY et al., Electron Devices Meeting, 2007, IEDM 2007, IEEE International, pages 693 à 696, 10-12 décembre 2007, et au document US 2007/0190754.

Dans l'exemple de mise en oeuvre faisant l'objet des figures 1A à 1J, le substrat 1 est un substrat de silicium monocristallin massif, les couches sacrificielles 3 et 4 sont en SiGe monocristallin avec des concentrations en Ge différentes et la couche superficielle 5 est en silicium monocristallin. La couche sacrificielle 3 possède une concentration en Ge supérieure à la concentration en Ge de la couche sacrificielle 4. La couche sacrificielle 3 sera dite à forte concentration en Ge tandis que la couche sacrificielle 4 sera dite à faible concentration en Ge.

Cette différence de concentration en Ge des couches sacrificielles 3 et 4 permettra une gravure sélective de la couche sacrificielle 3 par rapport à la couche sacrificielle 4 et ceci en présence de silicium monocristallin.

Les couches sacrificielles 3 et 4 et la couche superficielle 5 peuvent être formées sur la face 2 du substrat 1 par épitaxie selon des techniques connues de l'homme de l'art.

On procède ensuite à une étape de gravure sélective permettant d'éliminer la couche sacrificielle 3 comme le montre la figure 1B.

La gravure est réalisée par une méthode de gravure chimique en phase vapeur ou CVE (pour « Chemical Vapor Etching ») utilisant comme gaz de gravure l'acide chlorhydrique HCl mélangé à un gaz porteur, ceci à une température de gravure inférieure ou égale à 700°C.

Cette gravure sélective ne contamine en aucun cas les fonctions auto-alignées réalisées. Elle est simple à mettre en oeuvre. Elle semble impossible à réaliser, selon l'art antérieur, par des méthodes de gravures par voie plasma CF₄/Ar ou par voie humide. La gravure sera réalisée en présence d'un gaz porteur, par exemple l'hydrogène ou l'azote.

La concentration en germanium de la couche sacrificielle à forte concentration en Ge (couche 3) est supérieure ou égale à 30% tandis que la concentration en germanium de la couche sacrificielle à faible concentration en Ge (couche 4) est supérieure ou égale à 10% et inférieure à 30%. La différence de concentration en germanium entre les deux couches sacrificielles est d'au moins 15%.

L'épaisseur de la couche sacrificielle 3 est comprise entre 5 nm et 30 nm. L'épaisseur de la couche sacrificielle 4 est comprise entre 5 nm et 100 nm.

Les épaisseurs des couches sacrificielles en SiGe sont choisies de sorte à ne pas générer de défauts dans l'empilement et à garder une bonne sélectivité de gravure entre la couche à forte concentration en germanium et celle à faible concentration en germanium. Le rapport des épaisseurs « couche de SiGe à faible concentration en Ge/couche de SiGe à forte concentration en Ge » peut être compris entre 1/6 et 20. Avantageusement, ce rapport est supérieur ou égal à 1. Ceci permet de conserver une bonne sélectivité de gravure entre les couches de SiGe.

L'homme de l'art, saura adapter les épaisseurs des couches sacrificielles et leur concentration en germanium de façon à ne pas provoquer de relaxation plastique dans ces couches afin de ne pas générer de défauts cristallins dans l'empilement, ce qui serait préjudiciable au bon fonctionnement des composants à réaliser.

La température de gravure est comprise entre 450°C et 900°C. Avantageusement, la température de gravure sera choisie inférieure ou égale à 700°C. A cette température, la gravure, en plus d'être sélective entre deux couches de SiGe à différentes concentrations de Ge, est extrêmement sélective vis-à-vis du silicium environnant (substrat et couche superficielle), la vitesse de gravure du silicium étant négligeable (inférieure à 0,1 nm/min).

La pression totale du mélange gazeux lors de la gravure est par exemple comprise entre 200 et 101 300 Pa. La pression partielle d'hydrogène pourra se situer dans la gamme allant de 20 à 24 000 Pa. Le flux du mélange gazeux de gravure sera compris entre quelques litres standard et quelques dizaines de litres standard par minute. Le flux d'HCl sera compris entre quelques centaines de centimètres cube par minute et quelques dizaines de litres standard par minute. Le temps de gravure se situera entre plusieurs secondes et plusieurs centaines de secondes.

On peut choisir des pressions basses, avantageusement quelques milliers de Pa en pression totale et quelques dizaines de Pa en pression partielle d'HCl de façon à améliorer la sélectivité de gravure entre les couches sacrificielles. Au contraire, on peut choisir des pressions de gravure élevées (avantageusement quelques dizaines de milliers de Pa en pression totale et pression partielle) de façon à obtenir une très bonne vitesse de gravure. L'homme de l'art saura adapter les températures de gravure et les pressions de façon à conserver des sélectivités et des vitesses de gravure significatives pour les couches de SiGe, c'est-à-dire supérieures à 0,1 nm/min, et également pour trouver un bon compromis entre vitesse de gravure et sélectivité.

Plus la différence de concentration entre les deux couches de SiGe estélevée, plus la sélectivité de gravure est bonne. Plus la proportion en germanium de la couche de SiGe à forte concentration en Ge est élevée, plus il est possible de diminuer la température de gravure et la pression afin de mieux contrôler la sélectivité. Enfin, une augmentation de la pression totale, et plus particulièrement de la pression partielle d'HCl, augmente les vitesses de gravure mais dégrade la sélectivité entre les couches de SiGe à différence de concentration donnée. L'utilisation d'un substrat de départ original, autre que silicium massif, par exemple "strained SOI", "buffer SiGe"... permettra d'augmenter des degrés de liberté sur les épaisseurs et les concentrations en Ge des couches déposées et d'obtenir de meilleures sélectivités de gravure... L'utilisateur dudit procédé saura trouver les conditions (température et pression), particulièrement la composition des couches de SiGe pour obtenir les vitesses de gravure et sélectivités désirées.

A l'issue de cette étape de gravure sélective, la deuxième couche sacrificielle 4 et la couche superficielle 5 forment un pont au-dessus de la zone gravée de la première couche sacrificielle.

L'étape suivante comprend le dépôt d'une résine dans la zone gravée de la première couche sacrificielle et sur la couche superficielle pour enrober la couche superficielle. La figure 1C montre la structure obtenue qui comprend une couche de résine 6, entre le substrat 1 et la deuxième couche sacrificielle 4, et une couche de résine 7 recouvrant la couche superficielle 5.

La résine formant les couches 6 et 7 est une résine qui se transforme en matériau diélectrique après recuit. Le fait d'obtenir une couche diélectrique permet à la structure de supporter le budget thermique du procédé. De préférence, on choisira une résine HSQ (hydrogène silsesquioxane) qui permet de supporter le budget thermique induit par les étapes suivantes du procédé. La résine peut être déposée à 2 000 tours/minute.

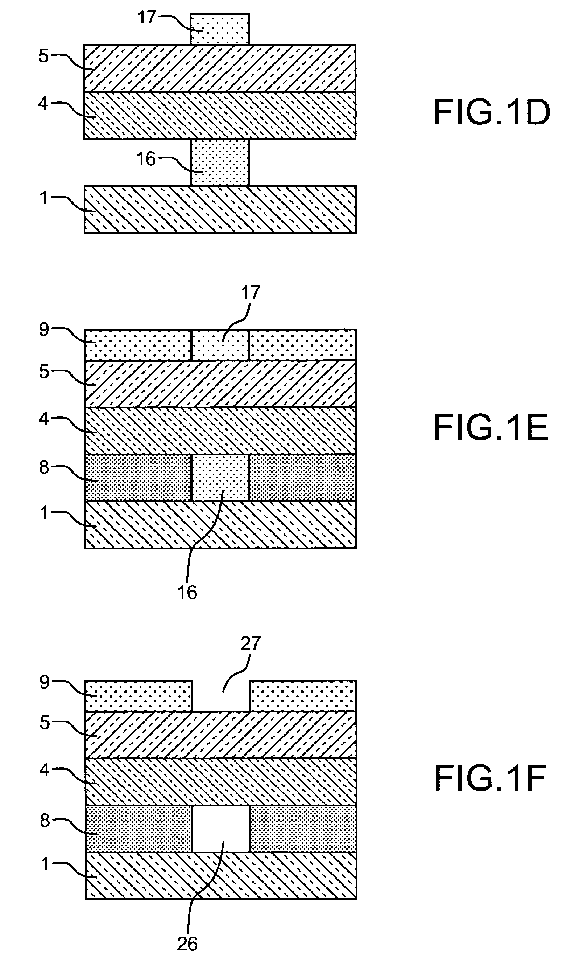

On procède ensuite à une étape de lithographie de la résine déposée à l'étape précédente, par exemple, au moyen d'un faisceau d'électrons qui va sensibiliser simultanément la couche de résine 7 et la couche de résine 6, après traversée de la couche superficielle 5 et de la deuxième couche sacrificielle 4. Le faisceau d'électrons possédera une énergie supérieure à 10 keV, par exemple une énergie de 100 keV pour 700 µC/Cm². Dans cet exemple de mise en oeuvre, on obtient, au développement de la résine, une zone de résine 16, transformée en un matériau diélectrique, dans la zone gravée de la première couche sacrificielle en alignement avec une zone de résine 17 sur la couche superficielle 5 (voir la figure 1D).

L'étape de lithographie peut aussi être réalisée au moyen d'un rayonnement électromagnétique de longueur d'onde comprise entre 0,1 nm et 41 nm, de préférence de longueur d'onde comprise entre 12,5 nm et 15 nm. La nature et l'épaisseur de la couche de résine déposée sur la couche superficielle ainsi que l'épaisseur de la couche superficielle sont choisies de manière qu'au moins 50% du rayonnement électromagnétique appliqué à la résine déposée sur la couche superficielle soit transmis à la résine déposée sur la zone gravée de la première couche sacrificielle.

La résine éliminée au cours de l'étape de lithographie dans la zone gravée de la première couche sacrificielle et sur la couche superficielle 5 est remplacée par un matériau de confinement des zones de résine 16 et 17. Le matériau de confinement est par exemple du nitrure de silicium. Ce matériau peut être déposé par LPCVD. La figure 1E montre la structure obtenue, une couche 8 confinant la zone de résine 16 entre le substrat 1 et la deuxième couche sacrificielle 4, une couche 9 confinant la zone de résine 17 sur la couche superficielle 5. Une opération de polissage mécanochimique (CMP) permet de révéler la zone de résine 17 transformée en matériau diélectrique.

On procède ensuite à la gravure des zones de résine subsistante 16 et 17. Si la résine utilisée est du HSQ, on peut employer une gravure HF humide. On obtient, comme le montre la figure 1F, des zones gravées et alignées 26 et 27.

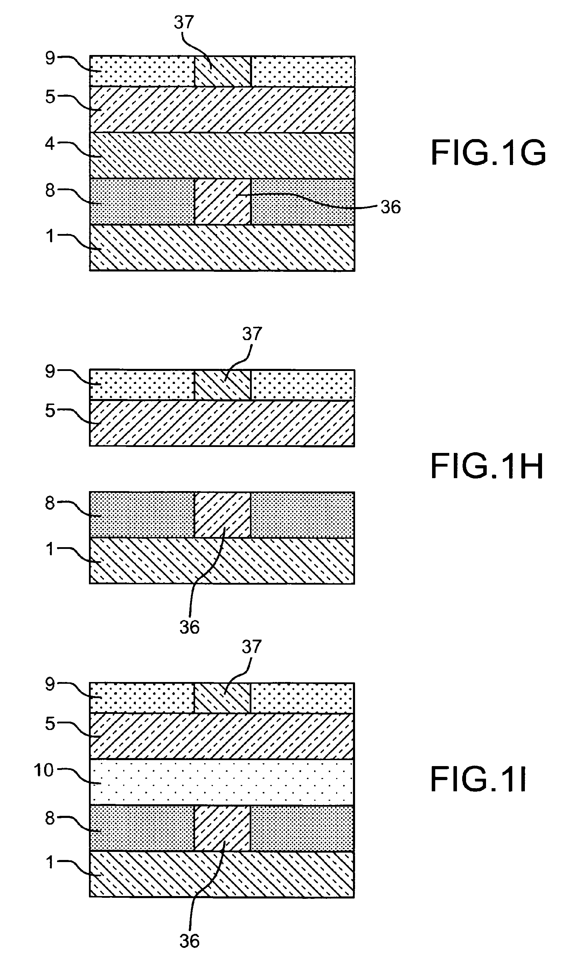

La structure est prête pour recevoir des éléments de composant dans les zones gravées et alignées. Ces éléments de composant, référencés 36 et 37 sur la figure 1G, sont par exemple constitués de couches déposées pour former des empilements de grille, par exemple des empilements HfO₂, TiN, silicium polycristallin. Comme pour la gravure de la zone de résine 16 (voir la figure 1E), la constitution de l'élément 36 est possible à partir d'un accès prévu lors de la formation des différentes couches de l'empilement des couches sacrificielles et de la couche superficielle.

On procède ensuite à l'élimination de la deuxième couche sacrificielle pour obtenir la structure représentée à la figure 1H, par exemple à l'aide d'un plasma isotrope CF₄. La couche superficielle 5 forme alors un pont au-dessus de la zone gravée de la deuxième couche sacrificielle.

A l'emplacement de la deuxième couche sacrificielle, un matériau diélectrique, servant à isoler électriquement les futurs composants entre eux, est introduit pour combler l'espace séparant la couche de confinement 8 de la couche superficielle de silicium 5. Il s'agit par exemple d'une couche d'oxyde de silicium 10 (couche HTO pour « High Température Oxide ») formée par LPCVD. La figure 1I montre la structure obtenue. L'épaisseur de la couche sacrificielle 4, définissant l'épaisseur de la couche diélectrique 10, sera choisie la plus épaisse possible pour réduire à son minimum le couplage entre les dispositifs empilés.

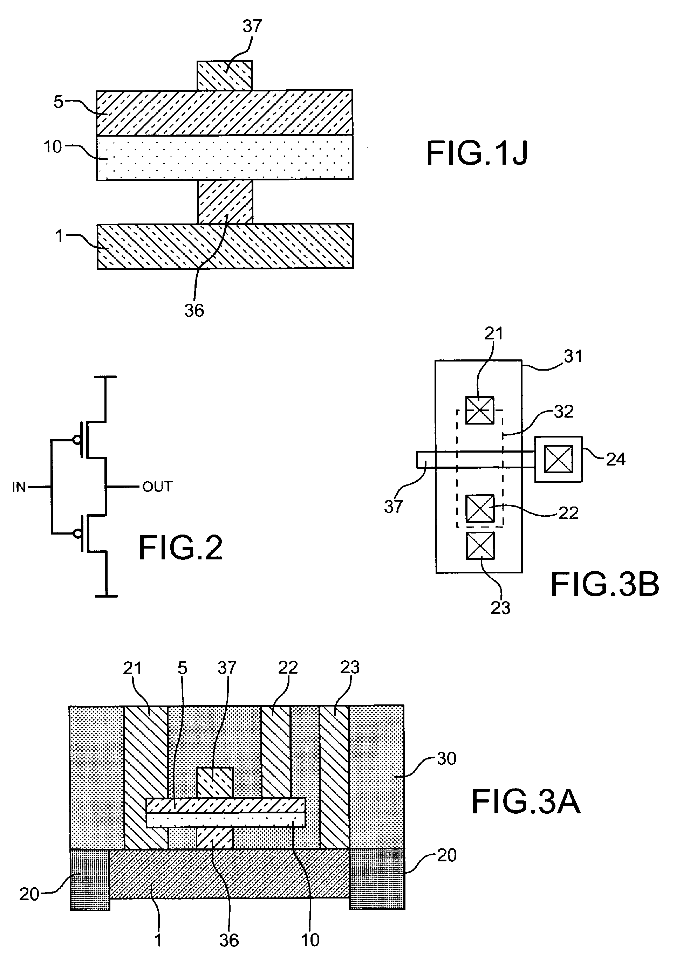

Les couches de confinement sont alors éliminées par gravure isotrope, par exemple par une solution de H₃PO₄, pour fournir la structure représentée à la figure 1J et possédant des empilements de grille 36 et 37 auto-alignés.

Le procédé peut alors se poursuivre par des étapes connues de l'homme de l'art (réalisation d'espaceurs, ...).

L'exemple de réalisation décrit précédemment partait d'un substrat massif en silicium monocristallin. Dans le cas du silicium, d'autres substrats peuvent être utilisés. Outre le substrat Si(001), on peut utiliser des substrats sSOI, XsSOI ou des substrats virtuels de SiGe pour augmenter le degré de liberté sur les épaisseurs, les concentrations en Ge des couches intermédiaires et obtenir les meilleures sélectivités de gravure... On pourrait envisager également d'utiliser des substrats d'orientation autre que (001), par exemple Si(110), Si(111)...

Un exemple d'application de la présente invention va être donné ci-dessous en référence aux figures 2, 3A et 3B.

L'inverseur est la porte logique fondamentale en technologie CMOS. Il est composé d'un transistor NMOS et d'un transistor PMOS connectés comme indiqué sur le schéma de la figure 2. L'entrée de l'inverseur est appelée IN et sa sortie est appelée OUT.

Les figures 3A et 3B sont des vues respectivement en coupe transversale et de dessus d'un inverseur CMOS empilé sur deux niveaux, selon la présente invention.

Sur la figure 3A, on a représenté avec les mêmes références les différents éléments de la structure représentée à la figure 1J. La structure est électriquement isolée des autres composants réalisés sur le substrat 1 par des tranchées d'isolation 20 dites STI (pour "Shallow Trench Isolation").

Les références 21, 22 et 23 désignent des connexions électriques aux transistors. La connexion 21 relie le drain de l'un des transistors à la source de l'autre transistor et assure la sortie OUT de l'inverseur. Les grilles des transistors sont au même potentiel.

Le matériau d'enrobage, référencé 30 sur la figure 3A, peut être un matériau de faible densité, par exemple SiO₂.

Sur la vue de dessus montrée à la figure 3B, on retrouve les connexions 21, 22 et 23 et l'empilement de grille 37. La référence 24 représente le contact commun aux deux grilles. Les références 31 et 32 représentent respectivement les zones actives du substrat, par exemple PMOS, et de la couche superficielle, par exemple NMOS.

Une structure particulière a été réalisée dans les conditions suivantes :
- substrat de Si,
- première couche sacrificielle en SiGe à 40 % de Ge, d'épaisseur 23 nm,
- deuxième couche sacrificielle en SiGe à 20 % de Ge, d'épaisseur 38 nm,
- couche superficielle de Si, d'épaisseur 33 nm,
- encapsulation par du nitrure de silicium d'épaisseur 40 nm.

Les températures de gravure appliquées se situent entre 550 et 600°C. Le gaz vecteur utilisé a été l'hydrogène tandis que le gaz de gravure était HCl. Les pressions partielles d'HCl et d'H₂ étaient de l'ordre de 24 000 Pa et 16 000 Pa, respectivement.

## Revendications

1. Procédé de fabrication de composants empilés et auto-alignés sur un substrat, comprenant les étapes suivantes :
- fourniture d'un substrat (1) en silicium monocristallin présentant une face (2) permettant la fabrication d'un composant,
- formation d'un empilement de couches sur la face du substrat, l'empilement comprenant une première couche sacrificielle (3) en SiGe monocristallin formée sur la face du substrat, une deuxième couche sacrificielle (4) en SiGe monocristallin formée sur la première couche sacrificielle, la concentration en germanium de la première couche sacrificielle (3) étant comprise entre 30% et 100%, la concentration en germanium de la deuxième couche sacrificielle (4) étant comprise entre 10% et 30%, la concentration en germanium de la première couche sacrificielle (3) étant d'au moins 15% supérieure à la concentration en germanium de la deuxième couche sacrificielle (4), et une couche superficielle (5) en silicium monocristallin permettant la fabrication d'un composant et formée sur la deuxième couche sacrificielle, lesdites couches de l'empilement étant formées de façon à permettre un accès à au moins une zone de la première couche sacrificielle (3) et à au moins une zone de la deuxième couche sacrificielle (4), ces zones étant empilées,
- gravure sélective de ladite zone de la première couche sacrificielle (3) par un mélange gazeux comprenant du HCl gazeux véhiculé par un gaz porteur et à une température comprise entre 450°C et 900°C, la deuxième couche sacrificielle (4) et la couche superficielle (5) formant un pont au-dessus de la zone gravée de la première couche sacrificielle (3),
- dépôt de résine (6, 7) dans la zone gravée de la première couche sacrificielle et sur la couche superficielle (5), la résine étant une résine qui se transforme en matériau diélectrique après recuit,
- lithographie de la résine déposée à l'étape précédente pour laisser subsister au moins une zone de résine (16) dans la zone gravée de la première couche sacrificielle, en alignement avec au moins une zone de résine (17) sur la couche superficielle (5),
- remplacement de la résine éliminée au cours de l'étape de lithographie dans la zone gravée de la première couche sacrificielle et sur la couche superficielle (5) par un matériau de confinement (8, 9) de la résine subsistante,
- élimination des zones de résine subsistantes dans la zone gravée de la première couche sacrificielle et sur la couche superficielle (5) pour fournir des zones (26, 27) dédiées à la fabrication de composants,
- formation d'éléments de composants (36, 37) dans les zones dédiées,
- gravure sélective de ladite zone de la deuxième couche sacrificielle, la couche superficielle (5) formant un pont au-dessus de ladite zone gravée de la deuxième couche sacrificielle.

2. Procédé de fabrication selon la revendication 1, dans lequel l'étape de fourniture d'un substrat (1) consiste à fournir un substrat choisi parmi un substrat de silicium massif, un substrat SOI, un substrat sSOI, un substrat XsSOI et un substrat virtuel de SiGe.

3. Procédé de fabrication selon l'une des revendications 1 ou 2, dans lequel l'étape de fourniture d'un substrat (1) consiste à fournir un substrat dont ladite face (2) comprend au moins un composant ou au moins une partie de composant.

4. Procédé de fabrication selon l'une quelconque des revendications 1 à 3, dans lequel le rapport de l'épaisseur de la deuxième couche sacrificielle (4) sur l'épaisseur de la première couche sacrificielle (3) est compris entre 1/6 et 20.

5. Procédé de fabrication selon l'une quelconque des revendications 1 à 4, dans lequel la gravure sélective de ladite zone de la première couche sacrificielle (3) est inférieure ou égale à 700°C.

6. Procédé de fabrication selon l'une quelconque des revendications 1 à 5, dans lequel la pression totale du mélange gazeux est comprise entre 200 et 101 300 Pa.

7. Procédé de fabrication selon l'une quelconque des revendications 1 à 6, dans lequel la résine (6, 7) déposée dans la zone gravée de la première couche sacrificielle et la résine déposée sur la couche superficielle (5) sont une résine qui se transforme en matériau diélectrique après exposition et/ou recuit.

8. Procédé de fabrication selon la revendication 7, dans lequel la résine est une résine HSQ (hydrogène silsesquioxane).

9. Procédé de fabrication selon l'une quelconque des revendications 1 à 8, dans lequel le matériau de confinement (8, 9) est du nitrure de silicium.

10. Procédé de fabrication selon l'une quelconque des revendications 1 à 9, dans lequel l'étape de formation d'éléments de composants comprend la formation d'au moins un élément de grille de transistor.

11. Procédé de fabrication selon l'une quelconque des revendications 1 à 10, dans lequel l'étape de gravure sélective de ladite zone de la deuxième couche sacrificielle est suivie d'une étape de remplissage de la zone gravée de la deuxième couche sacrificielle par un matériau électriquement isolant (10).

12. Procédé de fabrication selon la revendication 11, dans lequel le matériau électriquement isolant est un oxyde de silicium.

13. Procédé de fabrication selon l'une des revendications 1 à 12, dans lequel il est prévu une étape d'élimination du matériau de confinement (10).

14. Procédé de fabrication selon la revendication 1, dans lequel la lithographie de la résine déposée dans la zone gravée de la première couche sacrificielle et sur la couche superficielle est réalisée au moyen d'un faisceau d'électrons traversant la deuxième couche sacrificielle (4).

15. Procédé de fabrication selon la revendication 1, dans lequel la lithographie de la résine déposée dans la zone gravée de la première couche sacrificielle et sur la couche superficielle est réalisée au moyen d'un rayonnement électromagnétique de longueur d'onde comprise entre 0,1 nm et 41 nm, l'épaisseur et la nature de la résine (7) déposée sur la couche superficielle (5) ainsi que l'épaisseur de la couche superficielle étant choisies de manière qu'au moins 50% du rayonnement électromagnétique appliqué à la résine déposée sur la couche superficielle soit transmis à la résine (6) déposée dans la zone gravée de la première couche sacrificielle.

16. Procédé de fabrication selon la revendication 15, dans lequel la longueur d'onde du rayonnement électromagnétique est comprise entre 12,5 nm et 15 nm.

## Claims

1. Method for producing stacked and self-aligned components on a substrate, comprising the following steps:
- providing a substrate (1) made of monocrystalline silicon having one face (2) enabling the production of a component,
- forming a stack of layers on the face of the substrate, the stack comprising a first sacrificial layer (3) made of monocrystalline SiGe formed on the face of the substrate, a second sacrificial layer (4) made of monocrystalline SiGe formed on the first sacrificial layer, the germanium concentration of the first sacrificial layer (3) being between 30% and 100%, the germanium concentration of the second sacrificial layer (4) being between 10% and 30%, the germanium concentration of the first sacrificial layer (3) being at least 15% greater than the germanium concentration of the second sacrificial layer (4), and a superficial layer (5) made of monocrystalline silicon enabling the production of a component and formed on the second sacrificial layer, said layers of the stack being formed so as to enable an access to at least one zone of the first sacrificial layer (3) and to at least one zone of the second sacrificial layer (4), these zones being stacked,
- selective etching of said zone of the first sacrificial layer (3) by a gaseous mixture comprising gaseous HCl conveyed by a carrier gas and at a temperature between 450°C and 900°C, the second sacrificial layer (4) and the superficial layer (5) forming a bridge above the etched zone of the first sacrificial layer (3),
- depositing resin (6, 7) in the etched zone of the first sacrificial layer and on the superficial layer (5), the resin being a resin that transforms into dielectric material after annealing,
- lithography of the resin deposited at the preceding step to leave remaining at least one zone of resin (16) in the etched zone of the first sacrificial layer, in alignment with at least one zone of resin (17) on the superficial layer (5),
- replacing the resin eliminated during the step of lithography in the etched zone of the first sacrificial layer and on the superficial layer (5) with a material (8, 9) for confining the remaining resin,
- eliminating the remaining resin zones in the etched zone of the first sacrificial layer and on the superficial layer (5) to provide zones (26, 27) dedicated to the production of components,
- forming elements of components (36, 37) in the dedicated zones,
- selective etching of said zone of the second sacrificial layer, the superficial layer (5) forming a bridge above said etched zone of the second sacrificial layer.

2. Method of production according to claim 1, wherein the step of providing a substrate (1) consists in providing a substrate chosen among a bulk silicon substrate, an SOI substrate, an sSOI substrate, an XsSOI substrate and a virtual SiGe substrate.

3. Method of production according to one of claims 1 or 2, wherein the step of providing a substrate (1) consists in providing a substrate in which said face (2) comprises at least one component or at least one part of component.

4. Method of production according to any of claims 1 to 3, wherein the ratio of the thickness of the second sacrificial layer (4) over the thickness of the first sacrificial layer (3) is between 1/6 and 20.

5. Method of production according to any of claims 1 to 4, wherein the selective etching of said zone of the first sacrificial layer (3) is less than or equal to 700°C.

6. Method of production according to any of claims 1 to 5, wherein the total pressure of the gaseous mixture is between 200 and 101 300 Pa.

7. Method of production according to any of claims 1 to 6, wherein the resin (6, 7) deposited in the etched zone of the first sacrificial layer and the resin deposited on the superficial layer (5) are a resin that transforms into dielectric material after exposure and/or annealing.

8. Method of production according to claim 7, wherein the resin is a HSQ (hydrogen silsesquioxane) resin.

9. Method of production according to any of claims 1 to 8, wherein the confinement material (8, 9) is silicon nitride.

10. Method of production according to any of claims 1 to 9, wherein the step of forming elements of components comprises the formation of at least one transistor gate element.

11. Method of production according to any of claims 1 to 10, wherein the step of selective etching said zone of the second sacrificial layer is followed by a step of filling the etched zone of the second sacrificial layer with an electrically isolating material (10).

12. Method of production according to claim 11, wherein the electrically isolating material is a silicon oxide.

13. Method of production according to one of claims 1 to 12, wherein a step of eliminating the confinement material (10) is provided.

14. Method of production according to claim 1, wherein the lithography of the resin deposited in the etched zone of the first sacrificial layer and on the superficial layer is carried out by means of a beam of electrons passing through the second sacrificial layer (4).

15. Method of production according to claim 1, wherein the lithography of the resin deposited in the etched zone of the first sacrificial layer and on the superficial layer is carried out by means of an electromagnetic radiation of wavelength between 0.1 nm and 41 nm, the thickness and the nature of the resin (7) deposited on the superficial layer (5) as well as the thickness of the superficial layer being chosen so that at least 50% of the electromagnetic radiation applied to the resin deposited on the superficial layer is transmitter to the resin (6) deposited in the etched zone of the first sacrificial layer.

16. Method of production according to claim 15, wherein the wavelength of the electromagnetic radiation is between 12.5 nm and 15 nm.

## Patentansprüche

1. Verfahren zur Herstellung von gestapelten und selbstausgerichteten Komponenten auf einem Substrat, umfassend die folgenden Schritte:
- Bereitstellen eines Substrats (1) aus monokristallinem Silicium, das eine Fläche (2) aufweist, die die Herstellung einer Komponente ermöglicht,
- Bildung eines Stapels von Schichten auf der Fläche des Substrats, wobei der Stapel eine erste Opferschicht (3) aus monokristallinem SiGe, die auf der Fläche des Substrats gebildet ist, eine zweite Opferschicht (4) aus monokristallinem SiGe, die auf der ersten Opferschicht gebildet ist, wobei die Germanium-Konzentration der ersten Opferschicht (3) zwischen 30% und 100% ist, die Germanium-Konzentration der zweiten Opferschicht (4) zwischen 10% und 30% ist, wobei die Germanium-Konzentration der ersten Opferschicht (3) mindestens 15% größer als die Germanium-Konzentration der zweiten Opferschicht (4) ist, und eine Oberflächenschicht (5) aus monokristallinem Silicium, die die Herstellung einer Komponente ermöglicht und die auf der zweiten Opferschicht gebildet ist, umfasst, wobei die Schichten des Stapels so gebildet sind, dass ein Zugang zu mindestens einem Bereich der ersten Opferschicht (3) und zu mindestens einem Bereich der zweiten Opferschicht (4) ermöglicht wird, wobei diese Bereiche gestapelt sind,
- selektives Ätzen des Bereichs der ersten Opferschicht (3) mit einem Gasgemisch, das gasförmiges HCl, transportiert von einem Trägergas, umfasst, und bei einer Temperatur zwischen 450°C und 900°C, wobei die zweite Opferschicht (4) und die Oberflächenschicht (5) eine Brücke über dem geätzten Bereich der ersten Opferschicht (3) bilden,
- Ablagerung von Harz (6, 7) in dem geätzten Bereich der ersten Opferschicht und auf der Oberflächenschicht (5), wobei das Harz ein Harz ist, das sich nach dem Glühen in dielektrisches Material umwandelt,
- Lithographie des in dem vorhergehenden Schritt abgelagerten Harzes, um mindestens einen Harzbereich (16) in dem geätzten Bereich der ersten Opferschicht in Ausrichtung mit mindestens einem Harzbereich (17) auf der Oberflächenschicht (5) übrig zu lassen,
- Ersetzen des während des Lithographie-Schritts in dem geätzten Bereich der ersten Opferschicht und auf der Oberflächenschicht (5) entfernten Harzes durch ein Material zur Begrenzung (8, 9) des übrigen Harzes,
- Entfernen der übrigen Harzbereiche in dem geätzten Bereich der ersten Opferschicht und auf der Oberflächenschicht (5), um Bereiche (26, 27) bereitzustellen, die für die Herstellung von Komponenten vorgesehen sind,
- Bildung von Elementen von Komponenten (36, 37) in den vorgesehenen Bereichen,
- selektives Ätzen des Bereichs der zweiten Opferschicht, wobei die Oberflächenschicht (5) eine Brücke über dem geätzten Bereich der zweiten Opferschicht bildet.

2. Verfahren zur Herstellung gemäß Anspruch 1, wobei der Schritt des Bereitstellens eines Substrats (1) darin besteht, ein Substrat bereitzustellen, das aus einem festen Silicium-Substrat, einem SOI-Substrat, einem sSOI-Substrat, einem XsSOI-Substrat und einem virtuellen SiGe-Substrat ausgewählt ist.

3. Verfahren zur Herstellung gemäß einem der Ansprüche 1 oder 2, wobei der Schritt des Bereitstellens eines Substrats (1) darin besteht, ein Substrat bereitzustellen, bei dem die Fläche (2) mindestens eine Komponente oder mindestens einen Teil einer Komponente umfasst.

4. Verfahren zur Herstellung gemäß einem der Ansprüche 1 bis 3, wobei das Verhältnis der Dicke der zweiten Opferschicht (4) zu der Dicke der ersten Opferschicht (3) zwischen 1/6 und 20 ist.

5. Verfahren zur Herstellung gemäß einem der Ansprüche 1 bis 4, wobei das selektive Ätzen des Bereichs der ersten Opferschicht (3) kleiner als oder gleich 700°C ist.

6. Verfahren zur Herstellung gemäß einem der Ansprüche 1 bis 5, wobei der Gesamtdruck des Gasgemischs zwischen 200 und 101 300 Pa ist.

7. Verfahren zur Herstellung gemäß einem der Ansprüche 1 bis 6, wobei das in dem geätzten Bereich der ersten Opferschicht abgelagerte Harz (6, 7) und das auf der Oberflächenschicht (5) abgelagerte Harz ein Harz sind, das sich nach Belichtung und/oder Glühen in ein dielektrisches Material umwandelt.

8. Verfahren zur Herstellung gemäß Anspruch 7, wobei das Harz ein HSQ- (Wasserstoff-Silsesquioxan-) Harz ist.

9. Verfahren zur Herstellung gemäß einem der Ansprüche 1 bis 8, wobei das Material zur Begrenzung (8, 9) Siliciumnitrid ist.

10. Verfahren zur Herstellung gemäß einem der Ansprüche 1 bis 9, wobei der Schritt der Bildung von Elementen von Komponenten die Bildung von mindestens einem Transistor-Gate-Element umfasst.

11. Verfahren zur Herstellung gemäß einem der Ansprüche 1 bis 10, wobei auf den Schritt des selektiven Ätzens des Bereichs der zweiten Opferschicht ein Schritt des Auffüllens des geätzten Bereichs der zweiten Opferschicht mit einem elektrisch isolierenden Material (10) folgt.

12. Verfahren zur Herstellung gemäß Anspruch 11, wobei das elektrisch isolierende Material ein Siliziumoxid ist.

13. Verfahren zur Herstellung gemäß einem der Ansprüche 1 bis 12, wobei ein Schritt des Entfernens des Material zur Begrenzung (10) vorgesehen ist.

14. verfahren zur Herstellung gemäß Anspruch 1, wobei die Lithographie des in dem geätzten Bereich der ersten Opferschicht und auf der Oberflächenschicht abgelagerten Harzes mittels eines Elektronenstrahls, der durch die zweite Opferschicht (4) hindurchgeht, durchgeführt wird.

15. Verfahren zur Herstellung gemäß Anspruch 1, wobei die Lithographie des in dem geätzten Bereich der ersten Opferschicht und auf der Oberflächenschicht abgelagerten Harzes mittels elektromagnetischer Strahlung einer Wellenlänge zwischen 0,1 nm und 41 nm durchgeführt wird, wobei die Dicke und die Art des auf der Oberflächenschicht (5) abgelagerten Harzes (7) sowie die Dicke der Oberflächenschicht so ausgewählt werden, dass mindestens 50% der auf das auf der Oberflächenschicht abgelagerte Harz angewendeten elektromagnetischen Strahlung auf das in dem geätzten Bereich der ersten Opferschicht abgelagerte Harz (6) übertragen wird.

16. Verfahren zur Herstellung gemäß Anspruch 15, wobei die Wellenlänge der elektromagnetischen Strahlung zwischen 12,5 nm, und 15 nm ist.
